# EUROPEAN PATENT SPECIFICATION

(11) **EP 4 540 824 B1**
(45) Date of publication and mention of the grant of the patent: **18.11.2026**
(21) Application number: 23736475.7
(22) Date of filing: 16.06.2023
(51) Int. Cl.: G11C 29/00, G01R 33/12, G01R 33/032, G11C 11/16

(54) **METHOD FOR DETERMINING SWITCHING OF NANOMAGNETS**
VERFAHREN ZUM BESTIMMEN DES UMSCHALTENS VON NANOMAGNETEN
PROCÉDÉ DE DÉTERMINATION DE COMMUTATION DE NANO-AIMANTS

(30) Priority: 20.06.2022 EP 22179955
(43) Date of publication of application: 23.04.2025
(73) Proprietor: Quantum Design SA, 1400 Yverdon-les-Bains (CH)
(72) Inventor: RICKHAUS, Peter, 4054 Basel (CH)
(74) Representative: P&TS SA (AG, Ltd.)
(86) International application number: PCT/IB2023/056262
(87) International publication number: WO 2023/248080

(56) References cited:
- US-A1- 2021 356 497
- CUI JIZHAI ET AL: "Nanomagnetic encoding of shape-morphing micromachines", NATURE, NATURE PUBLISHING GROUP UK, LONDON, vol. 575, no. 7781, 1 November 2019 (2019-11-01), pages 164 - 168, XP036988491, ISSN: 0028-0836, [retrieved on 20191106], DOI: 10.1038/S41586-019-1713-2

## Description

### Technical domain

The present invention concerns a method for investigating the quality of a plurality of binary nanomagnets, for example in magnetic random access memory (MRAM).

### State of the Art

Magnetic random access memory (MRAM) is a non-volatile memory technology with excellent growth perspectives. It is currently being manufactured by semiconductor foundries and has the potential to replace memories in consumer electronics.

The quality control of MRAM wafers is critical. State of the art metrology methods either characterize the blanket quality, e.g. by the magneto-optical Kerr effect (MOKE) microscopy or electrically test individual MRAM bits, or nanomagnets, at the end of the fabrication process. For the latter electrical connections to the MRAM wafer, respectively to the magnetic nanopillars of the MRAM wafer have to be established.

However, to date no satisfactory metrology method exists, which is capable of determining the quality of an MRAM wafer after the crucial etching step in the fabrication process. Distinguishing good and bad wafers at this stage of fabrication would be cost effective, as wafers which do not pass a quality test can be sorted out and without the need to be further processed. This saves a significant amount of fabrication time, thus allowing foundries for higher overall throughput, and is significantly more cost-effective.

Document US2021/356497 A1 discloses a wafer probe test system for testing magnetic devices during manufacturing.

It is an object of this invention to overcome the shortcomings and limitations of the state of the art.

### Short disclosure of the invention

It is an aim of the present invention to provide a method for determining the quality of MRAM wafers and/or other arrangements nanomagnets with binary switching behaviour.

According to the invention, one or more of these aims are attained by the object of the attached claims, and especially by the independent claim.

In particular, one or more aims are attained by a method for characterizing a magnetic device including a plurality of binary nanomagnets.

The method is suitable for determining the switching behaviour of individual binary nanomagnets comprised in the magnetic device.

The term nanomagnet as used herein means a magnet having a typical diameter of 10nm to 10µm, or of 20nm to 5µm and a height of sub-nanometre, or "atomically flat", to 10 µm, preferably between 1nm and 50nm.

Nanomagnets may for example be made of one or more ferromagnetic metals, such as iron, cobalt or nickel, and may comprise further transitional metals, such as titanium, vanadium, chromium, or manganese.

The plurality of binary nanomagnets of the magnetic device may be arranged in an array. To this end, the nanomagnets may be arranged on or embedded in a carrier element. Nanomagnets may also be embedded in MRAM pillars, containing other materials and multiple magnetic layers.

Today, storage density of nanomagnetic arrays defined by the pitch size may be as low as 100nm. However, there is room for improvement and with SNVM a pitch size of as low as 10nm can be measured. Therefore, when SNVM is used to measure switching behaviour, nanomagnetic arrays with a density of as high as 1 nanomagnet / (10nm*10nm) can be examined.

The storage density of the plurality of nanomagnets examined by this method may for example range from 1 nanomagnets per (200nm * 200nm) to 1 nanomagnet per (100nm * 100nm), or from 1 nanomagnets per (100nm * 100nm) to 1 nanomagnet per (10nm * 10nm).

A magnetic device may comprise one or more of the carrier elements with the plurality of nanomagnets. A magnetic device may be a device for storing binary information, for example an MRAM wafer.

When arranged in an MRAM wafer, the nanomagnets are also referred to as nanopillars due to their cylindrical shape. Nanopillars in a MRAM wafer typically have diameters from 10nm to 1µm. The method is not restricted to an MRAM geometry but can be applied to any nanomagnets with a binary switching behaviour. In particular, the method is useful for any storage device comprising nanomagnets for encoding binary information in the magnetization direction of individual nanomagnets.

Preferably the magnetic stray field should differ by a value from 1 µT, to about 1mT, or about > 10 µT to 100 µT at the surface of an array of nanomagnets, such that the magnetic stray field is clearly distinguishable between the two binary states of the individual nanomagnets.

The nanopillars may be embedded in a MRAM wafer. If the nanopillars are embedded, the distance of the magnetic free layer to the surface should not be larger than the MRAM disc diameter and disc spacing.

In SNVM, the spatial resolution is defined by the distance between the measured surface of the nanomagnet and NV⁻ centre of the sensing probe, wherein a decrease in distance results in an increase in spatial resolution.

The plurality of nanomagnets may also be arranged in devices having a different geometry.

The method of this invention comprises
(i) providing a magnetic device, which is a binary nanomagnetic array, comprising one or more carrier elements on which the plurality of nanomagnets is arranged or in which the plurality of nanomagnets is embedded;
(ii) applying a saturation magnetic field (µ₀Hₛₐₜ) having a first direction to a plurality of binary nanomagnets to induce a first magnetic orientation in the plurality of nanomagnets,
(iii) applying a second magnetic field (µ₀H_{c}) having a second direction, which is different to the first direction, to the plurality of nanomagnets,
(iv) repeating steps (ii) to (iii) at least once,
(v) determining a first fraction or percentage (α) of nanomagnets which switched orientation in step (iii) and a second fraction or percentage (α₁) of nanomagnets which switched orientation in the repeated step (iii),
(vi) determining a statistical double-switching percentage β_{ideal} based on the determined first fraction or percentage α and the determined second fraction or percentage α₁ of nanomagnets which switched orientation;
(vii) determining the effective double-switching fraction or percentage (β) of individual nanomagnets which have switched orientation in step (iii) as well as in the repeat of step (iii), and
(viii) making a statement about the quality of the plurality of nanomagnets based on the comparison between the determined statistical double-switching percentage (β_{ideal}) and the determined effective double-switching percentage (β) of the plurality of nanomagnets.

While step (ii) is performed first and step (iii) after step (ii), the order of the other steps is less important, as long as they logically follow the workflow.

Steps of determining the first α and second α₁ fractions or percentages of switched nanomagnets may be performed after steps (ii) and steps (iii) based on measurements made on the plurality of nanomagnets, or it may be performed later based the data and/or images obtained from such measurements.

The second direction of the second magnetic field µ₀H_{c} is preferably directly opposed to the first direction of the saturation magnetic field µ₀Hₛₐₜ.

The statistical double-switching percentage β_{ideal} may for example be calculated as follows: ${β}_{ideal} = α * {α}_{1}$

The determination of β_{ideal} according to this equation considers only two step(ii)/step (iii) cycle, respectively one repeat of a step(ii)/step (iii) cycle.

The strength of the opposite magnetic field µ₀H_{c} applied in step (iii) is preferably inferior to the magnetic field strength required for saturation of the plurality of binary nanomagnets. The strength of the opposite magnetic field µ₀H_{c} applied in step (iii) is therefore preferably less than the saturation magnetic field µ₀Hₛₐₜ applied in step (ii)

For step (ii) the magnetic field strength is chosen such that a saturation stage is reached for the plurality of binary nanomagnets. The field strength typically depends on the magnetic material used, additional magnetic layers, such as the reference layer, and the thickness of the magnetic material. The field strength is also influenced by the diameter of the nanomagnets. As a result, the saturation field strength varies depending on the plurality of nanomagnets, respectively the array of nanomagnets. A typical field value for a saturation field may for example be a value in the range of 100 mT to 1 T.

The saturation magnetic field µ₀Hₛₐₜ is applied to initialize all binary nanomagnets in one state, having a first magnetic orientation.

The application of the opposite magnetic field µ₀H_{c} having an opposite direction to the saturation magnetic field µ₀Hₛₐₜ, induces switching of the magnetic orientation of a certain percentage of the binary nanomagnets. The strength of the opposite magnetic field µ₀H_{c} is within the thermally broadened coercive field range of the nanomagnets, to provide a finite probability that at least one and at most all except for one nanomagnets switches its magnetization direction.

When the cycle of applying the saturation magnetic field µ₀Hₛₐₜ of the first orientation and subsequently applying an opposite magnetic field µ₀H_{c} having the opposite direction is repeated, a second percentage α₁ of nanomagnets will again switch its orientation. When multiplying the percentage α of switching nanomagnets of step (iii) in the initial cycle with the percentage α₁ of switching nanomagnets in step (iii) of the repeat cycle, a statistical value is obtained, which indicated the statistical probability of double-switching β_{ideal} of the plurality of nanomagnets, which would be expected thermally.

To determine whether the percentage of nanomagnets which effectively switched in the initial step (iii) as well as in the repeat step (iii), i.e. the effective double-switch percentage β, the identity of the switching nanomagnets may be determined after the initial step (iii) as well as after the repeat step (iii). The identity may also be determined at a later stage based on data obtained from the measurements performed or images taken after each step (ii) and step (iii). Double-switching of an individual nanomagnet can then be determined.

In other words, it is verified for each of the individual nanomagnets which was used to determine α and α₁ whether any of these nanomagnets switched twice. The percentage of those nanomagnets which switched twice is then calculated as β.

The identification of an individual nanomagnet may be based on said nanomagnet's local information, such as its position. This local information of individual nanomagnets may be used to establish a map.

The identification of individual nanomagnets of the plurality of nanomagnets, which may be arranged in an array, is preferably be based on the local information of the individual nanomagnets, for example the position of a nanopillar in or on a MRAM wafer.

Preferably, the determination of the orientation and the position of the nanomagnets are performed in a magnetometry scanning step. Ideally, the scanning step is performed after step (iii), the application of the opposite magnetic field µ₀H_{c}. The scanning step is preferably preformed immediately after step (iii).

The scan should be performed over a statistically relevant amount of nanomagnets, which may be arranged in a wafer or a device. The scan should be configured to identify the binary status of orientation of each measured nanomagnet. In order to establish the uniform binary status of the nanomagnets following step (ii), the application of the saturation magnetic field µ₀Hₛₐₜ, a magnetometry scan may also be performed following this step.

Nanomagnets of binary nanomagnetic arrays are typically arranged at distances ranging from 250nm to 50nm from one another. Ideally, the scanning magnetometer should therefore be capable of achieving a maximum spatial resolution of less than 100nm, or less than 50 nm or less than 10nm.

A scanning and/or mapping of the plurality of nanopillars may be performed following each step (iii) to determine the orientation and the local information, such as the position of the individual binary nanopillars.

The spatial resolution and/or magnetic field sensitivity of commonly used magnetometry techniques methods known in the art, such as magnetic force microscopy (MFM) or Magneto-Optical Kerr Effect (MOKE) microscopy, is insufficient to reliably detect the differences in magnetic orientation of nanomagnets in MRAM devices.

Magnetometry mapping is therefore preferably be conducted using a scanning nitrogen vacancy magnetometry (SNVM). SNVM is particularly suited for this method, as it provides excellent magnetic field sensitivity and spatial resolution. The technology has advanced greatly in recent years and commercial SNVM microscopes are available today.

To achieve the required spatial resolution SNVM systems should comprise a solid-state lattice sensor probe, preferably made of a monocrystalline diamond, with a single colour centre. The colour centre is preferably a nitrogen vacancy point defect in the diamond lattice. The colour centre nitrogen vacancy defect should be located no more than 100 nm, no more than 50 nm, or no more than 20 nm, ideally no more than 10 nm from the sensing surface of the sensing solid state lattice probe.

However, SNVM systems have never been used to measure switching behaviour of binary nanomagnets. In particular, SNVM systems have never been used to detect switching in binary nanomagnetic arrays.

Moreover, SNVM is suitable for determining switching behaviour at ambient conditions. The system and samples therefore do not need to be cooled to and maintained at low temperature to allow for measurements under cryogenic conditions, as required by other methods, for example superconducting quantum interference device (SQUID) on tip magnetometry.

By comparing the determined statistical double-switching percentage β_{ideal} and the determined effective double-switching percentage β of the plurality of nanomagnets, a statement is made about the quality of the plurality of nanomagnets.

The statement may be made on the assumption that the quality of the plurality of nanomagnets, which may be arranged in an array, decreases with the increase of difference between the determined statistical double-switching percentage β_{ideal} and the determined effective double-switching percentage β.

Discrepancies between the determined statistical double-switching percentage β_{ideal} and the determined effective double-switching percentage β may for example result from physical or geometrical defects of the nanomagnets or deviations in the critical dimensions.

The quality may decrease with the increase of difference between the determined statistical double-switching percentage β_{ideal} and the determined effective double-switching percentage β. The quality may for example decrease proportionally with the increase of difference between the determined statistical double-switching percentage β_{ideal} and the determined effective double-switching percentage β.

The cycle of applying the saturation magnetic field µ₀Hₛₐₜ and subsequently the opposite magnetic field µ₀H_{c} may be repeated more than once.

When multiple repeats are preformed, a percentage αₙ of nanomagnets which switched orientation in repeat n of step (iii) is determined for each repeat n.

In one embodiment nanomagnets which switched orientation in repeat n of step (iii) are identified, wherein the statistical probability of multiple switching β_{ideal n+1} of the nanomagnets, which switched orientation in step (iii) is determined for any of the subsequent repeats n of step (iii), wherein the effective multiple-switching percentage βₙ₊₁ is determined cumulatively for all repeats, and wherein a statement about the quality of the plurality of nanomagnets is made based on the comparison between the statistical probability of multiple switching β_{ideal n+1} and the effective multiple switching percentage βₙ₊₁ of the plurality of nanomagnets.

When more than one repeat of the switching cycle, i.e. step (ii) and step (iii) of the method, are performed, the statistical probability of multiple switching β_{ideal n+1} may be calculated as a percentage according to the formula ${β}_{ideal n + 1} = α * {α}_{1} * … * {α}_{n} ,$ wherein n is the number of repeats.

It is also possible to determine, based on the magnetic history of the plurality of nanomagnets in combination with the local information of individual nanomagnets, which switched orientation after step (iii), preferably the first step (iii), the likelihood of a switching of nanomagnets with a defined local information in a subsequent repeat of step (iii).

In one embodiment, multiple repeats n of the switching cycle, i.e., the cycle of applying the saturation magnetic field µ₀Hₛₐₜ and subsequently the opposite magnetic field µ₀H_{c}, are performed, and identified nanomagnets which switched orientation m-times in n repeats are determined. The nanomagnets may for example be identified based in their position. The effective multiple switching percentage β_{(m,n)} of the plurality of nanomagnets can then be determined based on the switching behaviour of the nanomagnets.

For example, presuming the number of repeats of the switching cycles n equals 4 and the number of switches m equals 3. If the observed number of nanomagnets which switched exactly 3 times in 4 cycles is 20 and the total number of nanomagnets in the array is 100, then β_{(m,n)} equals 20%.

The statistical probability of multiple m-times switching β_{ideal(m,n)} of the plurality of nanomagnets can be determined according to binominal distribution as follows: ${β}_{ideal \left(m, n\right)} = n ! / \left(\left(n-m\right)!m!\right) * {\left〈α\right〉}^{m} * {\left(1-\left〈α\right〉\right)}^{\left(n-m\right)}$ wherein n is the number of repeats, m is the number of actual switching events and < α > = (α + α₁+....+ αₙ) / n.

Subsequently, a statement about the quality of the plurality of nanomagnets can be made based on the comparison between the statistical probability of m times switching β_{ideal(m,n)} and the effective multiple switching percentage β_{(m,n)}.

The method of this invention can be performed without the need for electrically contacting the nanomagnets or the device comprising the nanomagnets.

With respect to what is known in the art, the invention provides the advantage that it is a non-invasive technique to identify the status of a plurality of nanomagnets, in particular nanomagnets arranged in binary nanomagnetic arrays, such as binary information storage devices. The impact on the plurality of nanomagnets, respectively the device, is therefore minimal, such that the introduction of defects is avoided.

### Short description of the drawings

Exemplar embodiments of the invention are disclosed in the description and illustrated by the drawings in which:

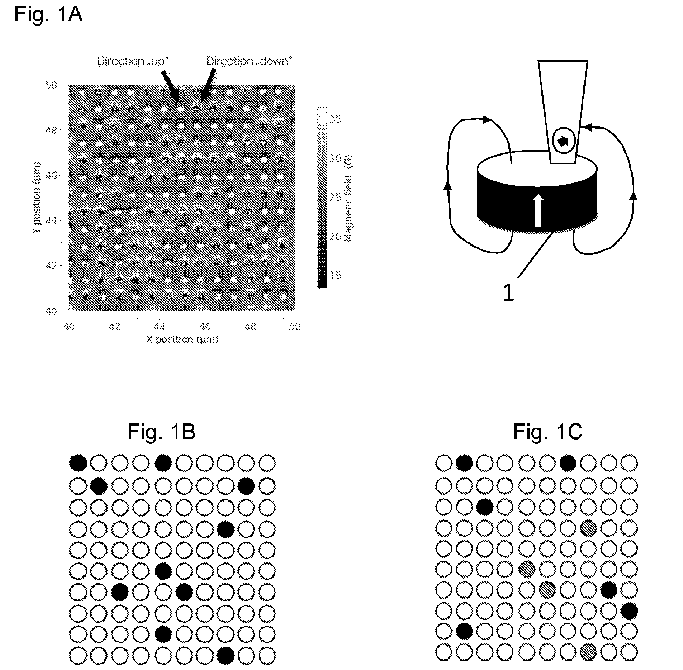

**Figure 1A** is an optically detected magnetic resonance scan of a portion of a MRAM wafer obtained with the SNVM system used in this study, the orientation of the spin defect in the sensor probe is indicated by an arrow; the orientation of magnetization of the cylindrical binary nanomagnet is also indicated with an arrow. The circular lines schematically represent the magnetic field lines.
**Figures 1B and 1C** schematically depict the same portion of a microarray after a switching cycle of applying a first saturated and subsequently a second alternate magnetic field; Nanomagnets which switched once are shown in dark grey, nanomagnets which switched twice, once in each cycle, are shown in white, medium grey nanomagnets did not switch;
Figure 1B shows nanomagnets after a first switching cycle
Figure 1C shows nanomagnets after a repeat switching cycle;
**Figures 2A****,** **2B** **and2C,** schematically depict the flow of subsequent the switching cycles and show the images obtained for each cycle after the application of the second magnetic field for inducing switching behaviour of the nanomagnets;

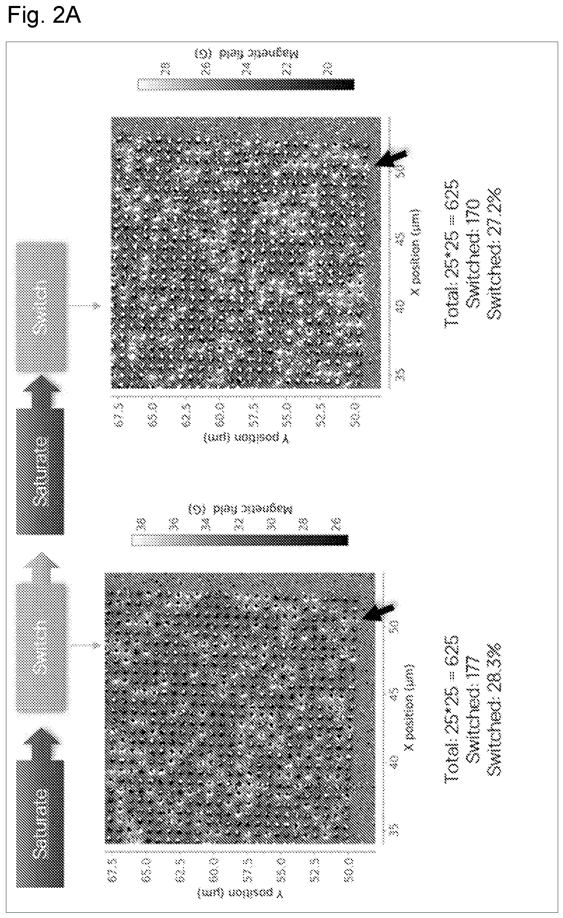

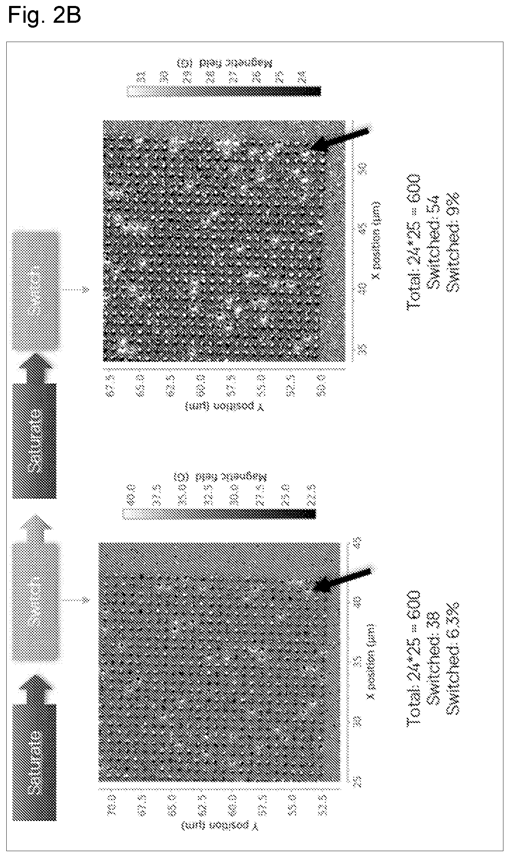

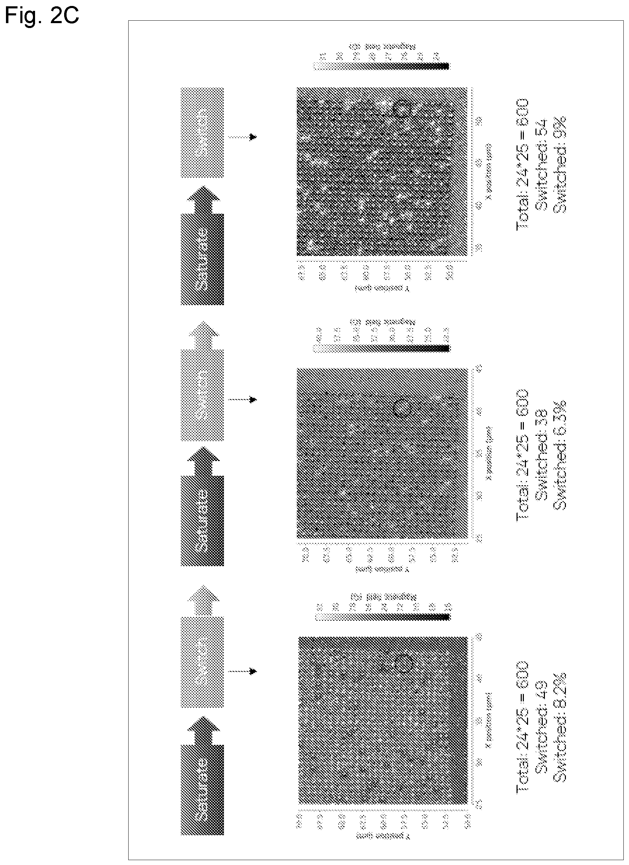

Figures 2A and 2B depict two examples of two consecutive switching cycles, and
Figure 2B depicts three consecutive switching cycles;

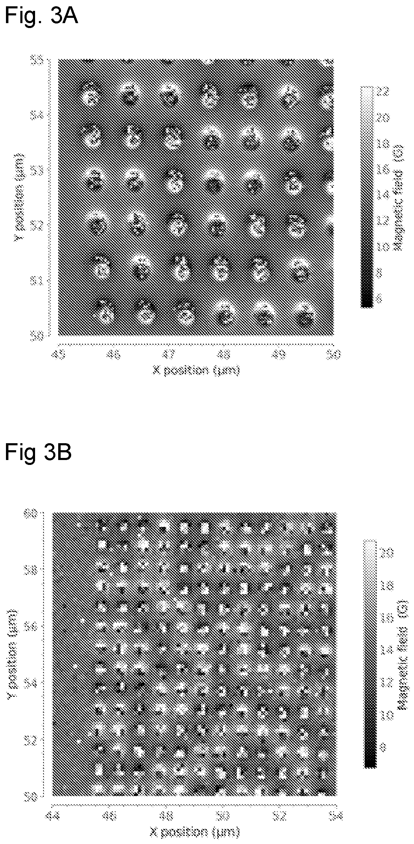

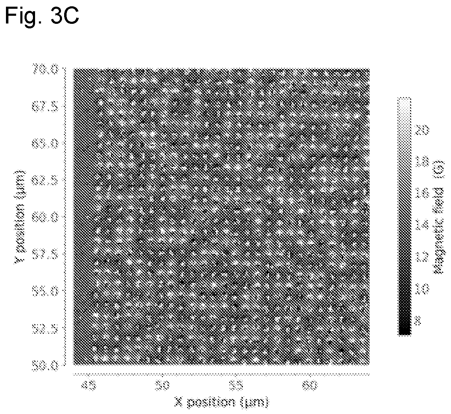

**Figures 3A, 3B** and **3C** are images obtained with the SNVM system used in this study of a portion of a MRAM wafer in Full-B mode, the sample magnetic field ranges of the sweep ranged from 6G or 8G to 20G or 22G, corresponding to a range of 0.6mT or 0.8mT to 20mT or 22mT with respect to the bias magnetic field applied along the NV⁻ centre axis in the range of 15G (0.15 mT);

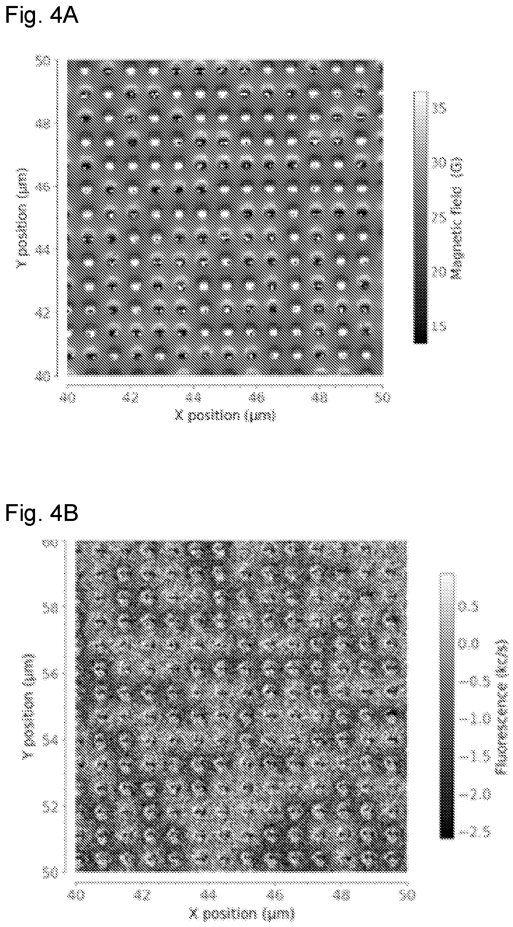

**Figure 4A** is an image obtained with the SNVM system used in this study of a portion of a MRAM wafer in Full-B mode over a measurement time of 3 hours; the magnetic field B_{NV} of the sweep ranged from 1.5mT to 3.5mT;
**Figure 4B** is an image obtained with the SNVM system used in this study of a portion of a MRAM wafer in dual iso-B mode corresponding to a magnetic field component of B_{NV}=0.2m; the grey scale indicates the fluorescence output signal in kilo counts per second (kc/s);

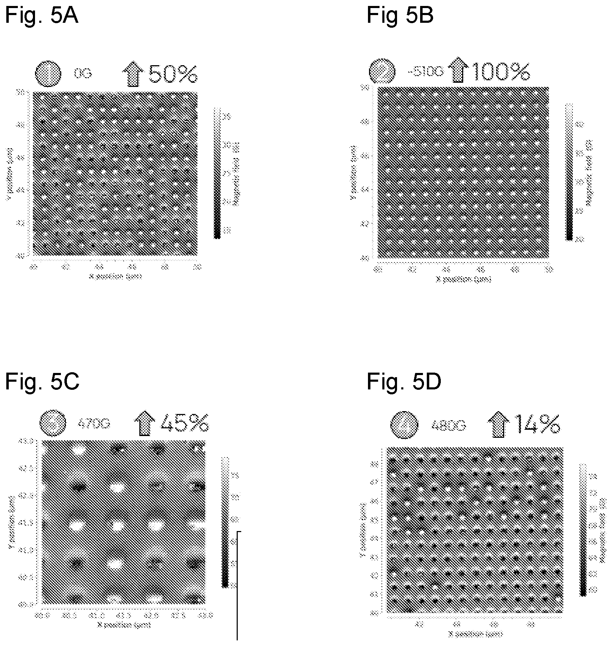

**Figures 5A to 5E** are images of magnetic sweeps detected with the SNVM system used in this study of a portion of a MRAM wafer; the sweeps were performed to the saturation field, and then back to a different field µ₀H_{c}, where a certain proportion of the nanomagnets switch. Measurements were taken around B_{NV}=0;

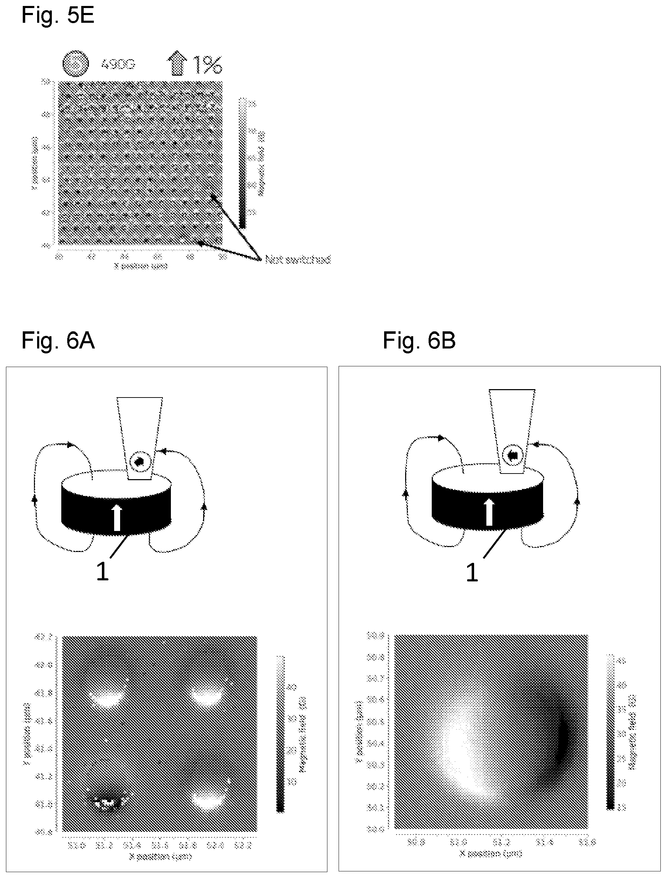

**Figures 6A to 6D** show images of the orientation of the magnetized nanomagnet obtained with the SNVFM system used in this study,
In Figure 6A orientation of spin of the NV center of the sensing probe was at an angle upward of 45° with respect to the measured surface of the nanomagnet;
In Figure 6B the orientation of spin of the NV center of the sensing probe was in plane with the measured surface of the nanomagnet;

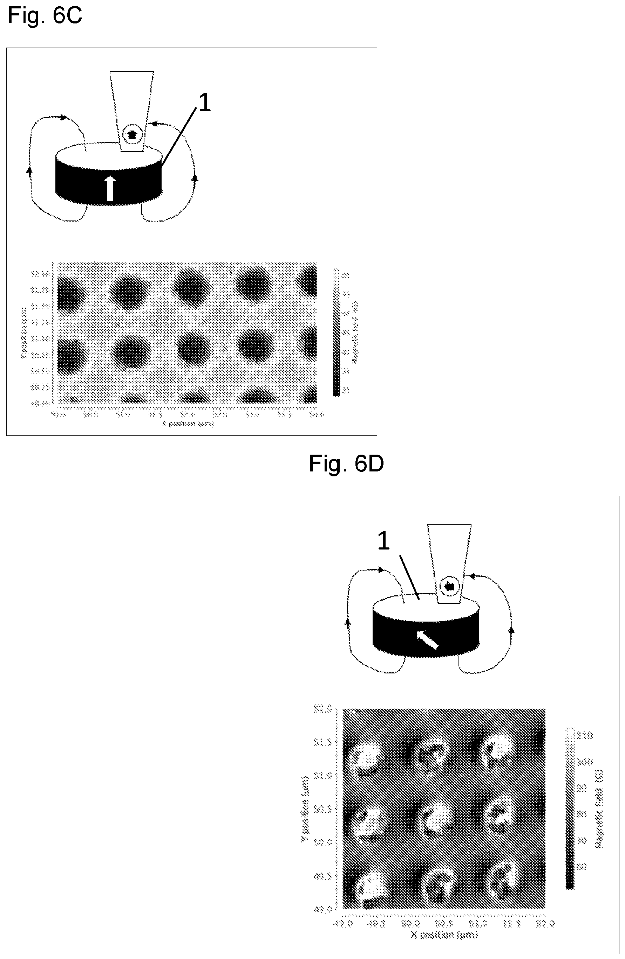

In Figure 6C orientation of spin of the NV center of the sensing probe was off plane with the measured surface of the nanomagnet;
In Figure 6D the magnetic field applied to the nanomagnet was tilted, wherein the orientation of spin of the NV center of the sensing probe was in plane with the measured surface of the nanomagnet;

### Examples of embodiments of the present invention

The Figures show results of examples of experiments performed according to the method of this invention.

In all the experimental set-ups of the results shown magnetic imaging was performed with a commercial SNVM (the Qnami ProteusQ, Qnami AG) operating under ambient conditions.

A commercial diamond tip hosting a single NV⁻ defect at its apex (Qnami, Quantilever MX) has an integrated quartz tuning fork to allow frequency modulation-based AFM (FM-AFM) and is scanned above an array of nanopillars arranged in a MRAM wafer.

The magnetic field strength indicated in some of the figures is given in the unit Gauss (G). As the skilled person knows, 10'000 G correspond to 1 Tesla (T). The strength of the magnetic fields measured in the depicted scans can therefore easily be converted into the SI unit T.

Figure 1A shows an magnetometry scan of a portion of an MRAM wafer. A first seep to a saturation field µ₀Hₛₐₜ was applied to the wafer, which put all the nanomagnets in the "direction down", as indicated in the image for an individual nanopillar. A subsequent sweep to a switching field µ₀H_{c} was then applied to switch a at least some of the nanomagnets into the "direction up", which is also indicated in the image for an individual nanopillar.

Figure 1A depicts an "as-grown" situation, i.e. a situation without magnetic history. Here, about 50% of the nanomagnets have a "down" direction and the remainder have a "up" direction. Examples of nanomagnetic arrays with magnetic history are provided in Figures 5A to 5E.

The detected magnetic field strength of the nanomagnets, which are nanopillars in this case, is indicated in grey scale. Each pillar can easily be localised using the cartesian X and Y axes beside the image. Some of the binary nanomagnets which have switched their magnetic orientation are indicated with an arrow. A schematic presentation of the nanomagnet 1 and the tip of the SNVM sensor probe scanning the surface of the nanomagnet is shown on the left to the scan. The white arrow in the nanomagnet indicates the orientation of its magnetization. The black arrow in the sensor tip indicates the orientation of the NV- centre, which is characterized by its polar angle θ_{NV} and its azimuthal angle φ_{NV}.

Nanomagnets with mostly white surfaces have one orientation of magnetization, wherein nanomagnets with mostly black surfaces have the opposite orientation of magnetization.

Figure 1B and 1C illustrate schematically an array of 100 nanomagnets after a first switching cycle (Fig 1B) and after a second switching cycle (Fig 1C).

A switching cycle as referred to herein consists of applying a first saturation magnetic field µ₀Hₛₐₜ having a first direction and subsequently applying a second magnetic field µ₀H_{c} having a second direction, which is different to the first direction, to the plurality of nanomagnets.

As can be seen in Figure 1B, 10% of the nanomagnets of the array have switched here polarization during the first switching cycle, which is indicated as a switch from white to black in this Figure. The first percentage α of nanomagnets which switched orientation in the first switching cycle is therefore 10%.

The same array, respectively portion of array, as applicable, is then subjected to a second switching cycle. Following this second cycle 10% of the nanomagnets have switched their magnetic orientation again, as is shown in Figure 1C. The second percentage α₁ of nanomagnets which switched orientation in the second switching cycle is therefore also 10%.

The nanomagnets shown in black or shown striped in Figure 1C have switched their polarization following the second switching cycle. The nanomagnets indicated in stripes are those who have switched their magnetic orientation twice, once during the first switching cycle and a second time during the second switching cycle. These nanomagnets are the effective double-switchers.

In this example of an array of 100 nanomagnets, 4 effective double switchers were identified. The double-switching percentage β is therefore 4%.

The number nanomagnets exhibiting double switching expected to occur based on thermal activation corresponds to the statistical double-switching percentage β_{ideal}. The statistical double-switching percentage β_{ideal} is a calculated theoretical value based on the detected number of switches in each switching cycle. It may be calculated as the second fraction or percentage α₁ applied to the first fraction or percentage α of switches which have occurred during the first switching cycle.

In this study, this ideal statistical double-switching percentage β_{ideal}, was be calculated as ${β}_{ideal} = α * {α}_{1}$

The statistical double-switching percentage β_{ideal} in the example shown is therefore 1%. However, the effective percentage β of double switches detected is 4%, 3% more than the thermally expected double-switches. This deviation of switching distribution from the ideal thermally expected double-switching percentage β_{ideal} indicates that the array of nanomagnets has a less than ideal behaviour, which may indicate issues with its quality. The deviation may be attributable to geometrical or physical defects of the array.

Figures 2A and 2B show a sequence of switching cycles and an SNVM scan of a portion of an MRAM wafer comprising an array of nanomagnets obtained after sweeping to the second magnetic field µ₀H_{c} of each cycle. The saturation magnetic field µ₀Hₛₐₜ is referred to a "saturate", and the second magnetic field µ₀H_{c} as "switch" in these figures.

The total numbers of nanomagnet assessed is indicated underneath each scan as "Total". the number of switched nanopillars and their percentage α, respectively α₁, is also indicated.

Figure 2A shows a sequence of two switching cycles. A selection of nanomagnets which have switched at least once, and a selection of nanomagnets which have switched in both cycles are indicated with arrows.

I Figure 2B a sequence of three switching cycles and their SNVM scans are shown.

The value for the statistical double-switching percentage β_{ideal} and for the effective double-switching percentage β can easily be determined from these Figures as outlined above. Figures 3A to 3C show different magnifications of SNVM scans of a portion of a MRAM wafer in Full-B mode. The sample magnetic field strength of the sweep performed in this study ranged from 6G or 8G to 20G or 22G, which is a range of 0.6mT or 0.8mT to 20mT or 22mT with corresponding to a range of 0.6mT or 0.8mT to 20mT or 22mT with respect to the bias magnetic field applied along the NV⁻ centre axis in the range of 15G (0.15 mT).

The results were taken on an "as-grown" wafer, i.e. a wafer without any previous magnetic field history. Whereas the overall distribution is entirely statistical, i.e. 50% of nanomagnets point in the same direction, the local distribution of orientations is not entirely random but distinct line-like patterns form. These "lines" are formed by nearest-neighbour nanomagnets. This is indicative of interactions between nearest-neighbouring nanomagnets, which provides relevant information for the MRAM fabrication process.

To determine the switching behaviour of the nanomagnets, a SNVM scan can be performed in a Full-B mode, as mentioned above. In Figure 4A a scan in full-B mode performed over a magnetic field sweep ranging from 1.5mT to 3.5mT was performed in 3h measuring time.

To obtain a quicker characterization of the magnetic device, respectively the plurality of nanomagnets, it is also possible to use SNVM to image two iso-magnetic field contours that are resonant to two specific microwave frequency f_{MW,1}, and f_{MW,2} hereinafter referred to as 'dual iso-B' mode. The fluorescence counts at f_{MW,1}, and f_{MW,2} are subtracted from each other.

In the scan shown in Figure 4B a scan in dual iso-B mode was performed on the same portion of MRAM wafer imaged in Figure 4A. The dual iso-B mode image shown in Figure 4B corresponds to the magnetic component of B_{NV}=2.5 mT. The grey scale in this figure indicates the fluorescence output signal in kilo counts per second (kc/s). The dual iso-B scan was performed in 20 mins retrieving 169 bits, or nanomagnets, wherein on bit comprised 236 pixels. The speed of the scan averages to 1 bit / 7 seconds. When the number of pixels per bit is reduced to 4, 1 bit / 100 ms can be retrieved. By further optimising the SVNM set-up, optical output detection and count, a further increase the scanning speed of about a factor 100 is possible. A scanning speed of about 1 bit / ms is therefore feasible.

It was observed during studies performed according to this invention, that a certain percentage of the MRAM nanomagnets switched more easily. The assumption can be made that a certain percentage will switch, because switching is probabilistic, i.e. "thermal". The percentage of bits, or nanomagnets, that flip depends on the magnetic history. Which individual bits flip and whether they flip more easily than other bits may depend on critical dimension, defects, nearest neighbour interactions and so on.

This phenomenon is demonstrated by the images shown in Figures 5A to 5E.

In these images, nanomagnets with mostly white surfaces have one orientation of magnetization, wherein nanomagnets with mostly black surfaces have the opposite orientation of magnetization.

The orientation of the nanomagnets is easily distinguishable in Figure 5C, for example. Here, one orientation is characterized by circles that have mostly a white contrast, with a dark-grey shade at the upper half-radius. The other orientation is characterized by circles that are mostly black, with a light-grey contrast at the upper half radius.

Figure 5A shows the as-grown status, where half of the nanomagnets point in one, and the other half in the other direction.

Figure 5B shows an image after a first saturation magnetic field µ₀Hₛₐₜ has been applied. Here all nanomagnets point in the same direction.

Figure 5C, Figure 5D and Figure E show results after a saturation magnetic field and a second magnetic field µ₀H_{c} was applied and where now 45%, 14%, or 1% of the nanomagnets point in one direction, as indicated in the respective Figures.

Based on the magnetic history of the plurality of nanomagnets, which are preferably arranged in an array, the likelihood of a switching of nanomagnets in a defined local area may be estimated. To this end, localisation maps may be used to identify which individual nanomagnets switch their orientation in a system or array of nanopillars having a certain magnetic history. The local information on individual nanomagnets can then be used to determine, if for example nearest-neighbour switching, or if switching at the edge of the array is more likely to occur.

It was furthermore observed that the orientation of the NV⁻ spin defect influenced the pattern of the image received for individual binary nanomagnets. This is effect is shown in Figures 6A to 6C, each schematically indicating the polarization of the nanomagnet with a white arrow and the orientation of the NV⁻ centre in the sensor tip with a black arrow. In each of these Figures, the orientation of magnetization of the nanomagnet is the same, i.e. orthogonal to the upper face of the nanopillar, while the polar angle θ_{NV} of the NV⁻ centre changes. The corresponding SNVM images obtained for each of these set-ups is shown underneath the respective illustration.

In Figure 6A the orientation of the spin is tilted off plane of the measured surface. The upper face of the nanopillar does not appear homogenous but has a bright and a dark portion in this polarization of the nanomagnet. In a switched polarization the imaged dark and bright portions would be inverted.

In Figure 6B the orientation of the spin is in plane with respect to the measured surface. As can be seen in the corresponding SNVM image, about half of the measured face of the nanopillar appears bright, and the other half appears dark. Again, a switching of the binary nanomagnet would result in a flipping of brightness of these halves.

In Figure 6C the orientation of the spin is entirely off plane with respect to the measured surface. The orientation of the spin is parallel to the magnetic orientation of the nanopillar. It is notable, that the SNVM image obtained for this kind of arrangement shows a uniform brightness of the measured surfaces of the nanopillars. In this case, all surfaces appear dark. It was noticed, that when used in this set-up, less pixels are required when the SNVM scan is performed in dual iso-B mode. The speed of the scan can therefore be optimized when performed using this set-up.

Figure 6D depicts a similar setup as shown in Figure 6B, however in this experiment the orientation the magnetization of the nanopillar was tilted with respect to its measured surface by the application of a field perpendicular to the nanopillar. The resulting image showed a more complex pattern of bright and dark zones on the face of the nanopillar. Due to the heterogenous distribution of bright and dark zones on the nanopillars, it is more difficult to ascertain the switching of an individual nanopillar. However, the canted magnetization angle of the nanopillar can be calculated from such maps. The canting behaviour under external field contains valuable information for MRAM characterization.

## Claims

1. A method for characterizing a magnetic device including a plurality of binary nanomagnets, which may be arranged in an array, comprising
(i) providing a magnetic device, which is a binary nanomagnetic array, comprising one or more carrier elements on which the plurality of nanomagnets is arranged or in which the plurality of nanomagnets is embedded;
(ii) applying a saturation magnetic field (µ₀Hₛₐₜ) having a first direction to a plurality of binary nanomagnets to induce a first magnetic orientation in the plurality of nanomagnets,
(iii) applying a second magnetic field (µ₀H_{c}) having a second direction, which is different to the first direction, to the plurality of nanomagnets,
**characterized in that** the method further comprises the steps of
(iv) repeating steps (ii) to (iii) at least once,
(v) determining a first fraction or percentage (α) of nanomagnets which switched orientation in step (iii) and a second fraction or percentage (α₁) of nanomagnets which switched orientation in the repeated step (iii),
(vi) determining a statistical double-switching percentage β_{ideal} based on the determined first fraction or percentage α and the determined second fraction or percentage α₁ of nanomagnets which switched orientation;
(vii) determining the effective double-switching fraction or percentage (β) of individual nanomagnets which have switched orientation in step (iii) as well as in the repeat of step (iii), and
(viii) making a statement about the quality of the plurality of nanomagnets is made based on the comparison between the determined statistical double-switching percentage (β_{ideal}) and the determined effective double-switching percentage (β) of the plurality of nanomagnets.

2. The method according to claim 1, wherein steps (ii) and (iii) are repeated once and wherein the statistical double-switching percentage β_{ideal} is determined as ${β}_{ideal} = α * {α}_{1} .$

3. The method according to claims 1 or 2, further comprising identifying individual nanomagnets which switched orientation in step (iii) and identifying individual nanomagnets which switched orientation in the repeat of step (iii).

4. The method according to claim 3, wherein the identification of an individual nanomagnet is based on said nanomagnet's local information, such as position.

5. The method according to claim 3 or 4, comprising the step of determining, based on the magnetic history of a plurality of nanomagnets in combination with the local information of the individual nanomagnets which switched orientation after step (iii), or which switched after a repeat n of step (iii), the likelihood of a switching of said individual nanomagnets with a defined local information in a subsequent repeat of step (iii), or after a subsequent repeat n+1 of said repeat n of step (iii).

6. The method according to any of claims 3 to 5, wherein steps (ii) and (iii) are repeated more than once, wherein a fraction or percentage (αₙ) of nanomagnets which switched orientation in repeat n of step (iii) is determined, wherein nanomagnets which switched orientation in repeat n of step (iii) are identified, wherein the statistical probability of multiple switching (β_{ideal n+1}) of the plurality of nanomagnets, is determined as ${β}_{ideal n + 1} = α * {α}_{1} * … * {α}_{n} ,$
wherein n is the number of repeats and wherein (αₙ) is the fraction or the percentage of nanomagnets which switched orientation in repeat n of step (iii),
wherein the effective multiple-switching percentage (βₙ₊₁) is determined cumulatively for all repeats, and
wherein a statement about the quality of the plurality of nanomagnets is made based on the comparison between the statistical probability of multiple switching (β_{ideal n+1}) and the effective multiple switching percentage (βₙ₊₁) of the plurality of nanomagnets.

7. The method according to any of claims 3 to 5, wherein steps (ii) and (iii) are repeated more than once, wherein a fraction or percentage (αₙ) of nanomagnets which switched orientation in repeat n of step (iii) is determined, wherein nanomagnets which switched orientation in repeat n of step (iii) are identified, wherein the statistical probability of nanomagnets switching m times in a series of n repeats (β_{ideal(m,n)}) is determined as ${β}_{ideal \left(m, n\right)} = n ! / \left(\left(n-m\right)!m!\right) {\left〈α\right〉}^{m} * {\left(1-\left〈α\right〉\right)}^{\left(n-m\right)} ,$ wherein $\left〈α\right〉 = \left(α+{α}_{1}+….+{α}_{n}\right) / n ,$
wherein n is the number of repeats, wherein (αₙ) is the fraction or percentage of nanomagnets which switched orientation in repeat n of step (iii), and wherein m is the number of actual switching events, and
wherein a statement about the quality of the plurality of nanomagnets is made based on the comparison between statistical probability of nanomagnets switching m times in a series of n repeats (β_{ideal(m,n)}) and effective multiple-switching percentage (β_{(m, n}), which is the fraction or the percentage of nanomagnets of the plurality of nanomagnets which switched orientation m times.

8. The method according to any of claims 1 to 7, wherein the determined quality of the device decreases with the increase of difference between the determined statistical double-switching percentage (β_{ideal}), respectively (β_{ideal n+1}) or (β_{ideal (m,n)}), and the determined effective double-switching percentage (β), respectively (βₙ₊₁) or (β_{(m, n}).

9. The methods according to any of claims 1 to 8, wherein the second direction is the opposite direction of the first direction.

10. The method according to any of claims 1 to 9, wherein a scanning or mapping of the plurality of nanomagnets is performed following each step (iii) to determine the orientation and the local information of the individual binary nanomagnets.

11. The method according to claim 10, wherein the mapping is performed by scanning magnetometry, preferably by scanning nitrogen vacancy magnetometry (SNVM).

12. The method according to any of claims 1 to 11, wherein the method is performed under ambient conditions.

13. The method according to any of claims 1 to 12, wherein the method is performed without electrically contacting the nanomagnets.

14. The method according to any of claims 1 to 13, wherein the magnetic device comprises one or more carrier elements on which the plurality of nanomagnets is arranged or in which the plurality of nanomagnets is embedded.

15. The method according to claim 14, wherein storage density of the plurality of nanomagnets ranges from 1 nanomagnets per (200nm * 200nm) to 1 nanomagnet per (100nm * 100nm), or from 1 nanomagnets per (100nm * 100nm) to 1 nanomagnet per (10nm * 10nm).

16. The method according to any of claims 1 to 15, wherein the magnetic device is a binary information storage device, such as used for magnetic random access memory (MRAM) wafer.

## Patentansprüche

1. Verfahren zur Charakterisierung einer magnetischen Vorrichtung mit einer Vielzahl von binären Nanomagneten, die in einem Array angeordnet sein können, umfassend
(i) Bereitstellen einer magnetischen Vorrichtung, die ein binäres nanomagnetisches Array ist, mit einem oder mehreren Trägerelementen auf dem oder denen die Vielzahl von Nanomagneten angeordnet ist oder in dem oder denen die Vielzahl von Nanomagneten eingebettet ist;
(ii) Anlegen eines Sättigungsmagnetfeldes (µ_{(0) Hsat}) mit einer ersten Richtung an eine Vielzahl von binären Nanomagneten, um eine erste magnetische Orientierung in der Vielzahl von Nanomagneten zu induzieren,
(iii) Anlegen eines zweiten Magnetfeldes (µ_{(0) Hc}) mit einer zweiten Richtung, die sich von der ersten Richtung unterscheidet, an die Vielzahl von Nanomagneten,
**dadurch gekennzeichnet, dass** das Verfahren ferner die folgenden Schritte umfasst
(iv) Wiederholen der Schritte (ii) bis (iii) mindestens einmal,
(v) Bestimmen eines ersten Anteils oder Prozentsatzes (α) von Nanomagneten, die in Schritt (iii) ihre Orientierung geändert haben, und eines zweiten Anteils oder Prozentsatzes (α₁) von Nanomagneten, die in dem wiederholten Schritt (iii) ihre Orientierung geändert haben,
(vi) Bestimmen eines statistischen Doppelschalt-Prozentsatzes β_{ideal} auf Grundlage des bestimmten ersten Anteils oder Prozentsatzes α und des bestimmten zweiten Anteils oder Prozentsatzes α₁ von Nanomagneten, die ihre Orientierung geändert haben,
(vii) Bestimmen des effektiven Doppelschalt-Anteils oder Prozentsatzes (β) einzelner Nanomagnete, die die Orientierung gewechselt haben, sowohl in Schritt (iii) als auch in der Wiederholung von Schritt (iii), und
(viii) auf Grundlage des Vergleichs zwischen dem ermittelten statistischen Doppelschalt-Anteil (β_{ideal}) und dem ermittelten effektiven Doppelschalt-Anteil (β) der Mehrzahl von Nanomagneten eine Aussage über die Qualität der Mehrzahl von Nanomagneten getroffen wird.

2. Verfahren nach Anspruch 1, wobei die Schritte (ii) und (iii) einmal wiederholt werden und wobei der statistische Doppelumschaltprozentsatz β_{ideal} bestimmt wird als ${β}_{ideal} = α * {α}_{1} .$

3. Verfahren nach Anspruch 1 oder 2, ferner umfassend das Identifizieren einzelner Nanomagnete, die in Schritt (iii) die Orientierung gewechselt haben, und das Identifizieren einzelner Nanomagnete, die in der Wiederholung von Schritt (iii) die Orientierung gewechselt haben.

4. Verfahren nach Anspruch 3, wobei die Identifizierung eines einzelnen Nanomagneten auf der lokalen Information des Nanomagneten, wie beispielsweise dessen Position, basiert.

5. Verfahren nach Anspruch 3 oder 4, umfassend den Schritt des Bestimmens, basierend auf der magnetischen Historie einer Vielzahl von Nanomagneten in Kombination mit der lokalen Information der einzelnen Nanomagneten, die die Orientierung nach Schritt (iii) umgeschaltet haben oder die nach einer Wiederholung n von Schritt (iii) umgeschaltet haben, der Wahrscheinlichkeit eines Umschaltens der einzelnen Nanomagneten mit einer definierten lokalen Information in einer nachfolgenden Wiederholung von Schritt (iii) oder nach einer nachfolgenden Wiederholung n+1 der Wiederholung n von Schritt (iii).

6. Verfahren nach einem der Ansprüche 3 bis 5, wobei die Schritte (ii) und (iii) mehr als einmal wiederholt werden, wobei ein Bruchteil oder Prozentsatz (αₙ) der Nanomagnete, die in der Wiederholung n des Schrittes (iii) die Orientierung umgeschaltet haben, bestimmt wird, wobei die Nanomagnete, die in der Wiederholung n des Schrittes (iii) die Orientierung umgeschaltet haben, identifiziert werden, wobei die statistische Wahrscheinlichkeit eines mehrfachen Umschaltens (β_{ideal n+1}) der Vielzahl der Nanomagnete bestimmt wird als ${β}_{ideal n + 1} = α * {α}_{1} * … * {α}_{n} ,$
wobei n die Anzahl der Wiederholungen ist und wobei (αₙ) der Bruchteil oder der Prozentsatz der Nanomagnete ist, die in der Wiederholung n des Schritts (iii) die Orientierung gewechselt haben,
wobei der effektive Prozentsatz der Mehrfachumschaltung (βₙ₊₁) kumulativ für alle Wiederholungen bestimmt wird, und
wobei aus dem Vergleich zwischen der statistischen Wahrscheinlichkeit des Mehrfachschaltens (β_{ideal n+1}) und dem effektiven Mehrfachumschaltprozentsatz (βₙ₊₁) der Vielzahl von Nanomagneten eine Aussage über die Qualität der Vielzahl von Nanomagneten getroffen wird.

7. Verfahren nach einem der Ansprüche 3 bis 5, wobei die Schritte (ii) und (iii) mehr als einmal wiederholt werden, wobei ein Bruchteil oder Prozentsatz (αₙ) von Nanomagneten, die in der Wiederholung n des Schrittes (iii) die Orientierung gewechselt haben, bestimmt wird, wobei Nanomagnete, die in der Wiederholung n des Schrittes (iii) die Orientierung gewechselt haben, identifiziert werden, wobei die statistische Wahrscheinlichkeit, dass Nanomagnete m-mal in einer Reihe von n Wiederholungen wechseln (β_{ideal (m,n)}), bestimmt wird als ${β}_{ideal \left(m, n\right)} = n ! / \left(\left(n-m\right)!m!\right) {\left〈α\right〉}^{\left(m\right) ∗} {\left(1-\left〈α\right〉\right)}^{\left(n-m\right)} ,$ wobei $\left〈α\right〉 = \left(α+{α}_{1}+….+{α}_{n}\right) / n ,$
wobei n die Anzahl der Wiederholungen ist, wobei (αₙ) der Bruchteil oder der Prozentsatz der Nanomagnete ist, die in der Wiederholung n von Schritt (iii) die Orientierung gewechselt haben, und wobei m die Anzahl der tatsächlichen Schaltvorgänge ist, und
wobei eine Aussage über die Qualität der Vielzahl von Nanomagneten auf der Grundlage des Vergleichs zwischen der statistischen Wahrscheinlichkeit, dass Nanomagnete m-mal in einer Reihe von n Wiederholungen schalten (β_{ideal (m,n)}) und dem effektiven Prozentsatz des Mehrfachschaltens (β_{(m, n)}), der der Bruchteil oder der Prozentsatz der Nanomagnete der Vielzahl von Nanomagneten ist, die m-mal die Orientierung geschaltet haben, getroffen wird.

8. Verfahren nach einem der Ansprüche 1 bis 7, wobei die ermittelte Qualität der Vorrichtung mit zunehmender Differenz zwischen dem ermittelten statistischen Doppelumschaltprozentsatz (β_{ideal}) , bzw. (β_{ideal n+1}) oder (β_{ideal (m,n)}), und dem ermittelten effektiven Doppelumschaltprozentsatz (β), bzw. (βₙ₊₁) oder (β_{(m, n)})_{,}abnimmt.

9. Verfahren nach einem der Ansprüche 1 bis 8, wobei die zweite Richtung die entgegengesetzte Richtung der ersten Richtung ist.

10. Verfahren nach einem der Ansprüche 1 bis 9, wobei nach jedem Schritt (iii) eine Abtastung oder Kartierung der Vielzahl von Nanomagneten durchgeführt wird, um die Orientierung und die lokalen Informationen der einzelnen binären Nanomagneten zu bestimmen.

11. Verfahren nach Anspruch 10, wobei das Mapping durch Scanning-Magnetometrie, vorzugsweise durch Scanning-Stickstoff-Vakanz-Magnetometrie (SNVM), durchgeführt wird.

12. Verfahren nach einem der Ansprüche 1 bis 11, wobei das Verfahren unter ambienten Bedingungen durchgeführt wird.

13. Verfahren nach einem der Ansprüche 1 bis 12, wobei das Verfahren ohne elektrische Kontaktierung der Nanomagnete durchgeführt wird.

14. Verfahren nach einem der Ansprüche 1 bis 13, wobei die magnetische Vorrichtung ein oder mehrere Trägerelemente umfasst, auf denen die Vielzahl von Nanomagneten angeordnet ist oder in die die Vielzahl von Nanomagneten eingebettet ist.

15. Verfahren nach Anspruch 14, wobei die Speicherdichte der Vielzahl von Nanomagneten von 1 Nanomagneten pro (200nm * 200nm) bis 1 Nanomagnet pro (100nm * 100nm) oder von 1 Nanomagneten pro (100nm * 100nm) bis 1 Nanomagnet pro (10nm * 10nm) beträgt.

16. Verfahren nach einem der Ansprüche 1 bis 15, wobei das magnetische Bauelement ein binäres Informationsspeicherbauelement ist, wie es für einen Magnetic Random Access Memory (MRAM)-Wafer verwendet wird.

## Revendications

1. Procédé de caractérisation d'un dispositif magnétique comprenant une pluralité de nanomagnets binaires, qui peuvent être disposés en réseau, comprenant
(i) la fourniture d'un dispositif magnétique, qui est un réseau de nanomagnets binaires, comprenant un ou plusieurs éléments de support sur lequel ou sur lesquels la pluralité de nanomagnets est disposée ou dans lequel ou dans lesquels la pluralité de nanomagnets est intégrée ;
(ii) l'application d'un champ magnétique de saturation (µ₀ Hₛₐₜ ) ayant une première direction à une pluralité de nanomagnets binaires afin d'induire une première orientation magnétique dans la pluralité de nanomagnets,
(iii) l'application d'un deuxième champ magnétique (µ₀ H_{c} ) ayant une deuxième direction, qui est différente de la première direction, à la pluralité de nanomagnets,
**caractérisé en ce que** le procédé comprend en outre les étapes consistant à
(iv) répéter les étapes (ii) à (iii) au moins une fois,
(v) déterminer une première fraction ou un premier pourcentage (α) de nanomagnets ayant changé d'orientation à l'étape (iii) et une deuxième fraction ou un deuxième pourcentage (α₁ ) de nanomagnets ayant changé d'orientation à l'étape (iii) répétée,
(vi) déterminer un pourcentage statistique de double inversion β_{idéal} sur la base de la première fraction ou du premier pourcentage α déterminé et de la deuxième fraction ou du deuxième pourcentage α₁ déterminé de nanomagnets ayant changé d'orientation,
(vii) déterminer la fraction ou le pourcentage effectif de double inversion (β) des nanomagnets individuels qui ont changé d'orientation à l'étape (iii) ainsi que lors de la répétition de l'étape (iii), et
(viii) formuler une conclusion sur la qualité de la pluralité de nanomagnets sur la base de la comparaison entre le pourcentage statistique de double inversion déterminé (β_{idéal}) et le pourcentage effectif de double inversion déterminé (β) de la pluralité de nanomagnets.

2. Procédé selon la revendication 1, dans lequel les étapes (ii) et (iii) sont répétées une fois et dans lequel le pourcentage statistique de double commutation β_{idéal} est déterminé comme suit ${β}_{idéal} = α * {α}_{1} .$

3. Procédé selon les revendications 1 ou 2, comprenant en outre l'identification des nanomagnets individuels qui ont changé d'orientation à l'étape (iii) et l'identification des nanomagnets individuels qui ont changé d'orientation lors de la répétition de l'étape (iii).

4. Procédé selon la revendication 3, dans lequel l'identification d'un nanomagnét individuel est basée sur les informations locales dudit nanomagnét, telles que sa position.

5. Procédé selon la revendication 3 ou 4, comprenant l'étape consistant à déterminer, sur la base de l'historique magnétique d'une pluralité de nanomagnets en combinaison avec les informations locales des nanomagnets individuels qui ont changé d'orientation après l'étape (iii), ou qui ont changé d'orientation après une répétition n de l'étape (iii), la probabilité d'un changement d'orientation desdits nanomagnets individuels présentant des informations locales définies lors d'une répétition suivante de l'étape (iii), ou après une répétition suivante n+1 de ladite répétition n de l'étape (iii).

6. Procédé selon l'une des revendications 3 à 5, dans lequel les étapes (ii) et (iii) sont répétées plus d'une fois, dans lequel une fraction ou un pourcentage (αₙ) de nanomagnets ayant changé d'orientation lors de la répétition n de l'étape (iii) est déterminé, dans lequel les nanomagnets ayant changé d'orientation lors de la répétition n de l'étape (iii) sont identifiés, dans lequel la probabilité statistique d'une commutation multiple (β_{idéal n+1} ) de la pluralité de nanomagnets est déterminée comme suit ${β}_{n + 1 idéal} = α * {α}_{1} * … * {α}_{n} ,$
dans lequel n est le nombre de répétitions et où (αₙ ) est la fraction ou le pourcentage de nanomagnets ayant changé d'orientation lors de la répétition n de l'étape (iii),
dans lequel le pourcentage effectif de commutation multiple (βₙ₊₁ ) est déterminé de manière cumulative pour toutes les répétitions, et
dans lequel une conclusion concernant la qualité de la pluralité de nanomagnets est tirée sur la base de la comparaison entre la probabilité statistique de commutation multiple (β_{idéal n+1} ) et le pourcentage effectif de commutation multiple (βₙ₊₁ ) de la pluralité de nanomagnets.

7. Procédé selon l'une des revendications 3 à 5, dans lequel les étapes (ii) et (iii) sont répétées plus d'une fois, dans lequel on détermine une fraction ou un pourcentage (αₙ ) de nanomagnets ayant changé d'orientation lors de la répétition n de l'étape (iii) est déterminée, dans laquelle les nanomagnets ayant changé d'orientation lors de la répétition n de l'étape (iii) sont identifiés, dans laquelle la probabilité statistique que des nanomagnets changent d'orientation m fois au cours d'une série de n répétitions (β_{idéal(m,n)} ) est déterminée comme suit ${β}_{idéal \left(m, n\right)} = n ! / \left(\left(n-m\right)!m!\right) {\left〈α\right〉}^{m} * {\left(1-\left〈α\right〉\right)}^{\left(n-m\right)} ,$ où $\left〈α\right〉 = \left(α+{α}_{1}+….+{α}_{n}\right) / n ,$
où n est le nombre de répétitions, où (αₙ ) est la fraction ou le pourcentage de nanomagnets ayant changé d'orientation lors de la répétition n de l'étape (iii), et où m est le nombre d'événements de commutation réels, et
dans laquelle une affirmation concernant la qualité de la pluralité de nanomagnets est formulée sur la base de la comparaison entre la probabilité statistique que les nanomagnets changent d'orientation m fois au cours d'une série de n répétitions (β_{idéal(m,n)} ) et le pourcentage effectif de commutations multiples (β_{(m, n)} ), qui est la fraction ou le pourcentage de nanomagnets parmi la pluralité de nanomagnets ayant changé d'orientation m fois.

8. Procédé selon l'une des revendications 1 à 7, dans lequel la qualité déterminée du dispositif diminue avec l'augmentation de la différence entre le pourcentage statistique de double commutation déterminé (β_{idéal} ), respectivement (β_{idéal n+1} ) ou (β_{idéal(m,n)} ), et le pourcentage de double commutation effectif déterminé (β), respectivement (βₙ₊₁ ) ou (β_{(m, n)} ).

9. Procédés selon l'une des revendications 1 à 8, dans lesquels la deuxième direction est la direction opposée à la première direction.

10. Procédé selon l'une des revendications 1 à 9, dans lequel un balayage ou une cartographie de la pluralité de nanomagnets est effectué après chaque étape (iii) afin de déterminer l'orientation et les informations locales de chacun des nanomagnets binaires.

11. Procédé selon la revendication 10, dans lequel la cartographie est réalisée par magnétométrie à balayage, de préférence par magnétométrie à balayage des lacunes d'azote (SNVM).

12. Procédé selon l'une des revendications 1 à 11, dans lequel le procédé est réalisé dans des conditions ambiantes.

13. Procédé selon l'une des revendications 1 à 12, dans lequel le procédé est mis en œuvre sans établir de contact électrique avec les nanomagnets.

14. Procédé selon l'une des revendications 1 à 13, dans lequel le dispositif magnétique comprend un ou plusieurs éléments de support sur lesquels la pluralité de nanomagnets est disposée ou dans lesquels la pluralité de nanomagnets est intégrée.

15. Procédé selon la revendication 14, dans lequel la densité de stockage de la pluralité de nanomagnets varie de 1 nanomagnet par (200 nm * 200 nm) à 1 nanomagnet par (100 nm * 100 nm), ou de 1 nanomagnet par (100 nm * 100 nm) à 1 nanomagnet par (10 nm * 10 nm).

16. Procédé selon l'une des revendications 1 à 15, dans lequel le dispositif magnétique est un dispositif de stockage d'informations binaires, tel que celui utilisé pour une plaquette de mémoire vive magnétique (MRAM).
